# EUROPEAN PATENT APPLICATION

(11) **EP 0 617 458 A2**
(43) Date of publication of application: **28.09.1994**
(21) Application number: 93120476.2
(22) Date of filing: 17.12.1993
(51) Int. Cl.: H01L 21/306

(54) **Etching solution and etching method for semiconductor therefor**

(30) Priority: 19.03.1993 JP 59758/93
(71) Applicant: MITSUBISHI DENKI KABUSHIKI KAISHA, Tokyo 100 (JP)
(72) Inventor: Kitano, Toshiaki, c/o Mitsubishi Denki K.K., Itami-shi, Hyogo-ken 664 (JP)
(74) Representative: KUHNEN, WACKER & PARTNER

(57) **Abstract**

An etching solution comprises organic acid and hydrogen peroxide mixed in a volume ratio of 1:1 to 200:1 with basic material added thereto to an amount that adjust the pH. The etching solution presents an eminent difference in the etching rate between GaAs/AlGaAs, GaAs/InGaAs, AlGaAs/InGaAs, InGaAs/AlGaAs, and InGaAs/GaAs, and a high selectivity etching is enabled easily and at high preciseness. Therefore, a precise control of an etching for a heterostructure semiconductor is enabled.

## Description

### FIELD OF THE INVENTION

The present invention relates to etching solution used for etching semiconductor and etching method using this etching solution.

### BACKGROUND OF THE INVENTION

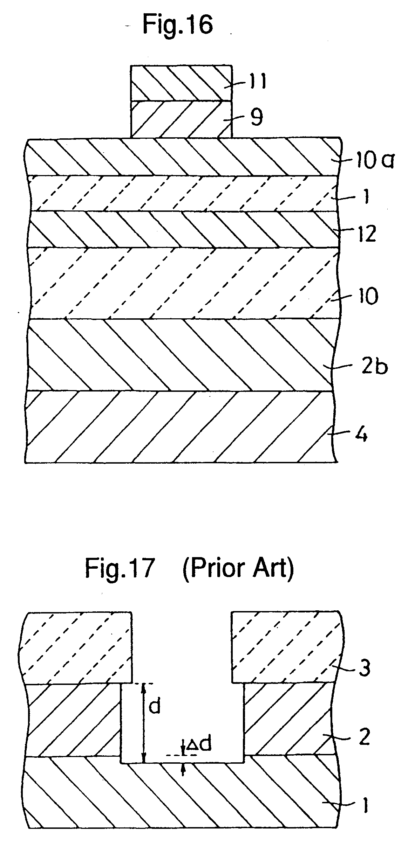

Conventionally, acid and hydrogen peroxide, base and hydrogen peroxide, or oxidation-reduction pair is employed as etching solution for etching semiconductor. Figure 17 is a cross sectional view illustrating a semiconductor device to which an etching is carried out using the prior art etching solution. In the figure, reference numeral 1 designates an n type AlGaAs layer. An n⁺ type GaAs layer 2 is disposed on the n type AlGaAs layer 1. A photoresist 3 is disposed on the n⁺ type GaAs layer 2. Reference character d designates an etching depth to that the n⁺ type GaAs layer 2 is etched and reference character Δd designates an over etching depth to that the n type AlGaAs layer 1 is excessively etched.

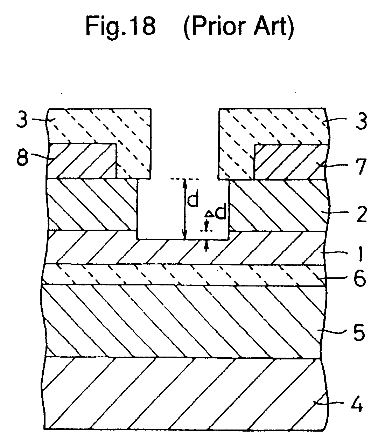

Figure 18 is a cross sectional view illustrating an HEMT (high electron mobility transistor) produced by employing a prior art etching solution. In the figure, the same reference numerals as in figure 17 designate the same elements. Reference numeral 4 designates a GaAs substrate. An i type GaAs layer 5 is disposed on the GaAs substrate 4. An i type InGaAs layer 6 is disposed on the i type GaAs layer 5. The n type AlGaAs layer 1 and the n⁺ type GaAs layer 2 are disposed on the i type GaAs layer 5 in figure 17. A drain electrode 7 and a source electrode 8 are disposed on the n⁺ type GaAs layer 2.

The threshold voltage Vₜₕ of this HEMT is represented by the following formula (1): 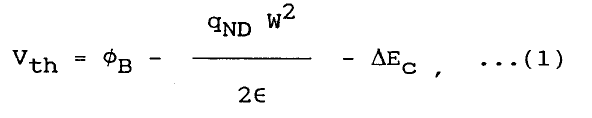
where
- φ_{B}:: Schottky barrier height
- W:: thickness of AlGaAs layer
- N_{D}:: donor concentration in AlGaAs layer
- ΔE_{c}:: energy discontinuity of the conduction band between AlGaAs and GaAs
- ε:: dielectric constant of AlGaAs
A description is given of the prior art etching method.

When a mixed solution of phosphoric acid, hydrogen peroxide, and water in a volume ratio of 3:1:50 is employed as an etching solution in figures 17 and 18, the etching speeds of the n⁺ type GaAs layer 2 and the n type AlGaAs layer 1 are both about 30 nm/min., and therefore, when this etching solution is applied to producing a gate recess of HEMT, there arises a variation Δd in the recess depth (d) in figures 17 and 18.

Since the thickness W of the AlGaAs layer 1 which appears in the formula (1) defining the threshold voltage Vₜₕ of the HEMT, is determined by the recess depth (d), the thickness W of the AlGaAs layer 1 varies when the recess depth (d) varies as described above, occurring a variation in the threshold voltage Vₜₕ, finally resulting in a variation in the characteristics of the HEMT.

The prior art etching solution does not have selectivity for the difference of material as described above, and when it is used in producing a heterostructure device, a precise control was difficult.

### SUMMARY OF THE INVENTION

It is an object of the present invention to provide an etching solution for performing an etching to a semiconductor layer structure comprising GaAs/AlGaAs, GaAs/InGaAs, AlGaAs/InGaAs, InGaAs/AlGaAs, and InGaAs/GaAs, that is selective dependent on the difference of the material.

It is another object of the present invention to provide an etching method for performing a precise and easy selective etching to a semiconductor device having the above described heterostructure, employing the above-described etching solution.

Other objects and advantages of the present invention will become apparent from the detailed description given hereinafter; it should be understood, however, that the detailed description and specific embodiment are given by way of illustration only, since various changes and modifications within the scope of the invention will become apparent to the those skilled in the art from the detailed description.

According to a first aspect of the present invention, an etching solution comprises a mixed solution of organic acid and hydrogen peroxide mixed in a volume ratio of 1:1 to 200:1 with basic material being added thereto so as to produce a pH of 6.0 to 8.0. An etching method comprises etching a GaAs layer selectively with an AlGaAs layer for a layer structure comprising the AlGaAs layer and the GaAs layer produced thereon. This may be applied to a layer structure comprising an n type AlGaAs layer and an n⁺ type GaAs layer produced thereon, of a HEMT.

According to a second aspect of the present invention, an etching solution comprises a mixed solution of organic acid and hydrogen peroxide mixed in a volume ratio of 1:1 to 200:1 with basic material being added thereto so as to produce a pH of above 6.0. An etching method comprises etching a GaAs layer selectively with an InGaAs layer for a layer structure comprising the InGaAs layer and the GaAs layer produced thereon. This may be applied to a layer structure comprising an n type InGaAs layer and an n⁺ type GaAs layer produced thereon, of a MESFET.

According to a third aspect of the present invention, an etching solution comprises a mixed solution of organic acid and hydrogen peroxide mixed in a volume ratio of 1:1 to 200:1 with basic material being added thereto so as to produce a pH of above 7.0. An etching method comprises etching an AlGaAs layer selectively with an InGaAs layer for a layer structure comprising the InGaAs layer and the AlGaAs layer produced thereon. This may be applied to a layer structure comprising a p⁺ type InGaAs base layer and an n type AlGaAs layer produced thereon, of a HEMT.

According to a fourth aspect of the present invention, an etching solution comprises a mixed solution of organic acid and hydrogen peroxide mixed in a volume ratio of 1:1 to 200:1 with basic material being added thereto so as to produce a pH of 4.5 to 5.5. An etching method comprises etching an InGaAs layer selectively with an AlGaAs layer for a layer structure comprising the InGaAs layer and the AlGaAs layer produced thereon. This may be applied to a layer structure comprising an n type AlGaAs emitter layer and an n type InGaAs emitter layer produced thereon, of an HBT.

According to a fifth aspect of the present invention, an etching solution comprises a mixed solution of organic acid and hydrogen peroxide mixed in a volume ratio of 1:1 to 200:1 with basic material being added thereto so as to produce a pH of 4.5 to 5.5. An etching method comprises etching an InGaAs layer selectively with a GaAs layer for a layer structure comprising the GaAs layer and the InGaAs layer produced thereon. This may be applied to a layer structure comprising an n type GaAs emitter layer and an n type InGaAs emitter layer produced thereon, of a HEMT.

According to the present invention, in etching a semiconductor material comprising two or more layers, the etching rate is differentiated dependent on the difference of the material to be etched, thereby presenting an eminent selectivity. Furthermore, the etching method employing the above-described etching solution enables a high preciseness control in the etching that affects significant influences on the characteristics of a heterostructure device.

### BRIEF DESCRIPTION OF THE DRAWINGS

Figure 1 is a diagram representing the pH dependency of etching rate, of an etching solution according to a first embodiment of the present invention.

Figure 2 is a diagram showing cross sectional views for explaining an etching method according to the first embodiment of the present invention.

Figure 3 is a cross sectional view for explaining a recess etching of a HEMT according to the first embodiment of the present invention.

Figure 4 is a diagram representing the pH dependency of etching rate, of an etching solution according to a second embodiment of the present invention.

Figure 5 shows cross sectional views for explaining an etching method according to the second embodiment of the present invention.

Figure 6 is a cross sectional view for explaining a recess etching of a HEMT according to the second embodiment of the present invention.

Figure 7 is a diagram representing the pH dependency of etching rate, of an etching solution according to a third embodiment of the present invention.

Figure 8 is a diagram showing cross sectional views explaining an etching method according to the third embodiment of the present invention.

Figure 9 is a cross sectional view for explaining a surface exposing etching of an HBT according to the third embodiment of the present invention.

Figure 10 is a diagram for explaining the external base resistance at the surface exposing etching of the HBT according to the third embodiment of the present invention.

Figure 11 is a diagram representing the pH dependency of etching rate, of an etching solution according to a fourth embodiment of the present invention.

Figure 12 is a diagram showing cross sectional views for explaining the etching method according to the fourth embodiment of the present invention.

Figure 13 is a diagram showing cross sectional views for explaining an HBT including an emitter layer that is depleted according to the fourth embodiment of the present invention.

Figure 14 is a diagram representing the pH dependency of etching rate, of an etching solution according to a fifth embodiment of the present invention.

Figure 15 is a diagram showing cross sectional views explaining an etching method according to the fifth embodiment of the present invention.

Figure 16 is a cross sectional view for explaining the etching of the emitter layer of the HBT according to the fifth embodiment of the present invention.

Figure 17 is a cross sectional view for explaining the prior art etching method.

Figure 18 is a cross sectional view for explaining the recess etching of the prior art HEMT.

### DETAILED DESCRIPTION OF THE PREFERRED EMBODIMENTS

### Embodiment 1.

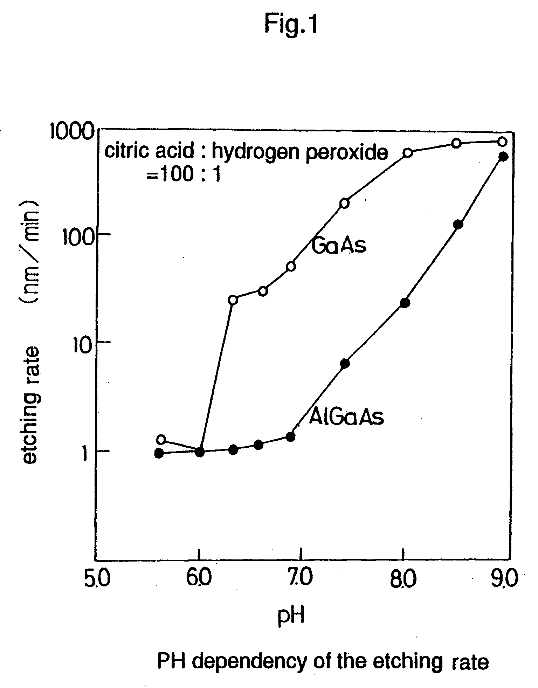

Figure 1 is a diagram for explaining an etching solution according to a first embodiment of the present invention. This figure shows the pH dependency of etching rate against GaAs and AlGaAs, of an etching solution obtained from citric acid as organic acid and hydrogen peroxide mixed in a volume ratio of 100:1. As organic acid, generally known organic acid, for example, malic acid, malonic acid, oxalic acid, tartaric acid, and succinic acid may be employed in the present invention. The volume ratio of the organic acid and the hydrogen peroxide may be within a range from 1:1 to 200:1, and then it represents the pH dependency of etching rate for GaAs and AlGaAs similar to that shown in figure 1.

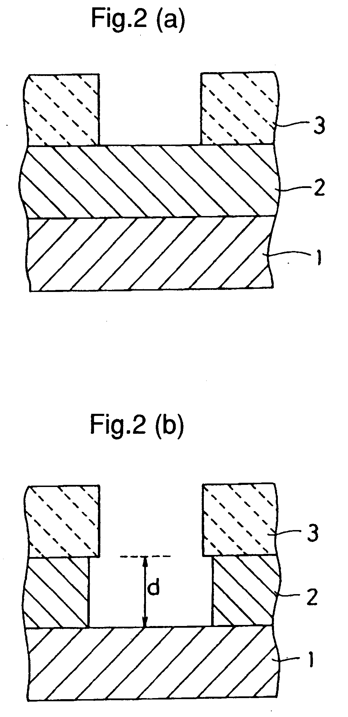

Figure 2(a) and (b) show an etching method according to a first embodiment of the present invention. In figure 2, reference numeral 1 designates an n type AlGaAs layer, reference numeral 2 designates an n⁺ type GaAs layer, and reference numeral 3 designates photoresist.

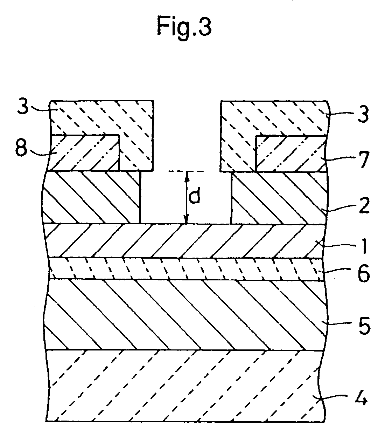

Figure 3 is a diagram for explaining a recess etching of an HEMT employing an etching solution according to a first embodiment of the present invention. In figure 3, reference numeral 1 designates an n type AlGaAs electron supply layer, reference numeral 2 designates an n⁺ type GaAs cap layer (ohmic contact layer), reference numeral 3 designates photoresist, reference numeral 4 designates a GaAs substrate, reference numeral 5 designates an i type GaAs buffer layer, reference numeral 6 designates an i type InGaAs channel layer, reference numeral 7 designates a drain electrode, and reference numeral 8 designates a source electrode.

Impurity concentration and thickness of respective layers of the HEMT are shown in the following table 1.

**Table 1**

| layer | impurity concentration | thickness |
|---|---|---|
| n type AlGaAs electron supply layer 1 | 2 x 10¹⁸cm⁻³ | 450Å |
| n⁺ type GaAs cap layer 2 | 3 x 10¹⁸cm⁻³ | 1,000Å |
| i type GaAs buffer layer 5 | | 3,000Å |
| i type InGaAs channel layer 6 | | 200Å |

A description is given of the etching solution and etching method according to the first embodiment.

As shown in figure 1, when citric acid is employed as organic acid and the volume ratio of citric acid and hydrogen peroxide to be mixed is made 100:1, and the pH is adjusted by adding basic compound such as ammonia thereto, a selective etching between GaAs and AlGaAs is possible within a range of pH 6.0 to 8.0. That is, the etching rate of GaAs is large and the etching rate of AlGaAs is small in this range of pH 6.0 to 8.0, thereby it is possible that GaAs is etched a lot and AlGaAs is hardly etched. In other words, as shown in figure 2, by performing etching to the two layer structure comprising the n type AlGaAs layer 1 and the n⁺ type GaAs layer 2 produced thereon, only the n⁺ GaAs layer 2 is etched and the etching can be stopped just at the n type AlGaAs layer 1. This can be also applied to a case where the n⁺ type GaAs cap layer 2 on the n type AlGaAs electron supply layer 1 is selectively etched in a recess etching of an HEMT as shown in figure 3. Because the etching depth (d) of the n⁺ type GaAs layer 2 can be controlled at high preciseness, the problem of occurring variation in the threshold voltage Vₜₕ in the prior art etching method is solved, thereby the characteristics of the HEMT is made uniform.

Japanese Published Patent Application No.63-62235 discloses a method of performing an etching to a GaAs layer selectively with an AlGaAs mixture crystalline layer using a solution comprising ammonia and hydrogen peroxide in a volume ratio of 1:750 to 1:1500. However, even when a mixture solution of ammonia and hydrogen peroxide that has not adjusted its pH is employed, an eminent difference in the etching rate as in this first embodiment is not obtained.

To the contrary, in this first embodiment in which the etching solution is obtained by mixing organic acid and hydrogen peroxide in a volume ratio of 1:1 to 200:1 and basic material is added thereto to produce a pH of 6.0 to 8.0, an eminent difference in the etching rate is resulted between the GaAs layer and the AlGaAs layer, thereby resulting an easy and high preciseness selective etching.

### Embodiment 2.

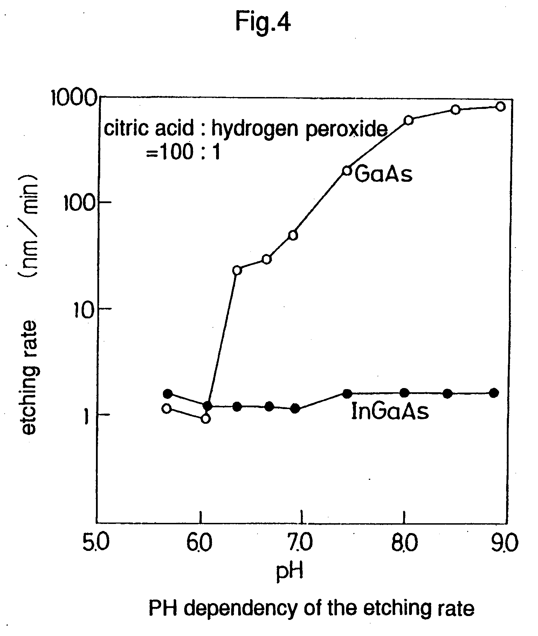

Figure 4 is a diagram for explaining an etching solution according to a second embodiment of the present invention. In this second embodiment, citric acid is employed as organic acid, and the citric acid and the hydrogen peroxide are mixed in a volume ratio of 100:1. The pH dependency of the etching rates for GaAs and InGaAs are shown in the figure 4. While in this second embodiment citric acid is employed similar to the first embodiment, generally known organic acid as those raised in the first embodiment can be employed. The volume ratio of the citric acid and the hydrogen peroxide may be in a range of 1:1 to 200:1, and then the pH dependency of etching rate against GaAs and InGaAs similar to that of figure 4 are obtained.

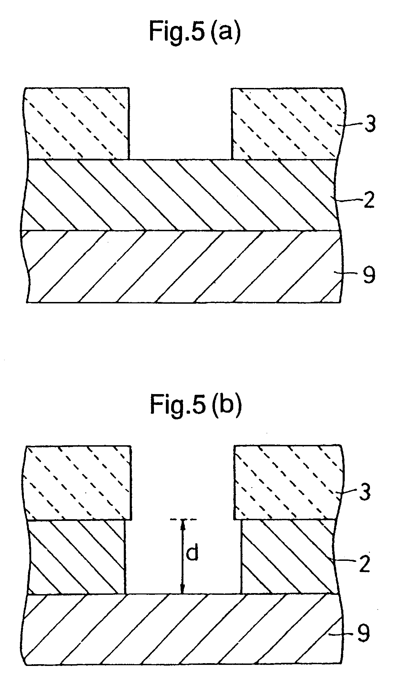

Figure 5 is a diagram showing an etching method according to a second embodiment of the present invention, where reference numeral 2 designates an n⁺ type GaAs layer, reference numeral 9 designates an n type InGaAs layer, and reference numeral 3 designates photoresist.

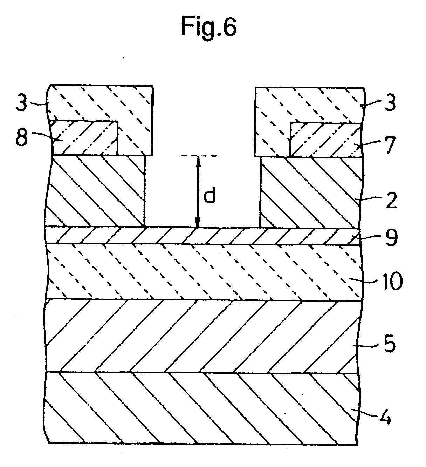

Figure 6 is a diagram explaining a recess etching of a MESFET employing an n type InGaAs as a stopper layer 9 employing the etching solution according to the second embodiment, where reference numeral 3 designates photoresist, reference numeral 7 designates a drain electrode, and reference numeral 8 designates a source electrode.

The impurity concentration and thickness of respective layers of this MESFET will be described in the following table 2.

**Table 2**

| layer | impurity concentration | thickness |
|---|---|---|
| GaAs substrate 4 | | |
| GaAs/AlGaAs super-lattice buffer layer 5 (=GaAs of 50Å x 40/AlGaAs of 150Å x 40) | | 8,000Å |
| n GaAs channel layer 10 | 3 x 10¹⁷cm⁻³ | 1,500Å |
| n type InGaAs stopper layer 9 | 2 x 10¹⁷cm⁻³ | 100 to 200Å |
| n⁺ type GaAs cap layer 2 | 2 x 10¹⁸cm⁻³ | 1,000 to 3,000Å |

The threshold voltage Vₜₕ of this MESFET will be represented as follows: 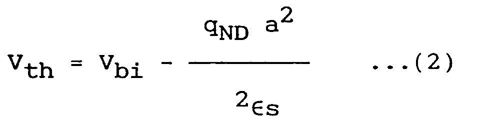
where
- V_{bi}:: built-in potential
- q:: electron charge
- N_{D}:: doner concentration
- a:: active layer thickness (corresponding to the thickness of 9 and 10 of figure 6)
- εₛ:: dielectric constant.

Next, the etching solution and the etching method of the second embodiment will be described.

As shown in figure 4, when citric acid is employed as organic acid, the citric acid and the hydrogen peroxide are mixed in a volume ratio of 100:1, and the pH is adjusted to be in a range of pH above 6.0 by adding, for example, basic compound such as ammonia thereto, the selective etching between GaAs and InGaAs is made possible. In other words, in this range of pH above 6.0, the etching rate of GaAs is large and the etching rate of InGaAs is small, thereby the GaAs is etched a lot and InGaAs is hardly etched. Thus, by performing an etching to the two layer structure of n type InGaAs layer 9 and n⁺ type GaAs layer 2 employing photoresist 3 as a mask as shown in figure 5, only the n⁺ GaAs layer 2 is etched and the etching is stopped just at the n type InGaAs layer 9.

This etching can be applied to a case where a recess etching of a MESFET is performed using the InGaAs layer as a stopper layer 9 as shown in figure 6. Then, the etching depth (d) can be controlled at high preciseness, thereby the active layer thickness (a) (the thickness of layers of InGaAs stopper layer 9 and n type GaAs layer 10 in figure 6) becomes uniform, thereby solving the problem of arising variations in the threshold voltage Vₜₕ due to the variations in the active layer thickness (a) in the formula (2) representing the threshold voltage Vₜₕ of the MESFET.

As a selective etching method for a layer structure comprising a GaAs layer and an InGaAs layer of HEMT or MESFET that require a high preciseness control, disclosed is in Japanese Published Patent Application No. 2-206117 a method in which an etching solution of citric acid, hydrogen peroxide, and water is employed, and an AlAs layer is formed between a GaAs layer and an InGaAs layer as an etching stopper layer in a thickness of about 30 Å that does not prevent the passing through of an electron. In this method, however, providing a process step of forming an AlAs layer in the fabrication process of HEMT or MESFET unfavourably increases the process number itself, and thereby complicating the fabrication process.

On the contrary, in the second embodiment of the present invention, because the etching solution is adjusted to have a pH value of above 6.0 by adding basic compound to the mixture solution of organic acid and hydrogen peroxide mixed in a volume ratio of 1:1 to 200:1, an AlAs layer is not required to be formed between the GaAs layer and the InGaAs layer, thereby enabling a selective etching easily and at high preciseness.

### Embodiment 3.

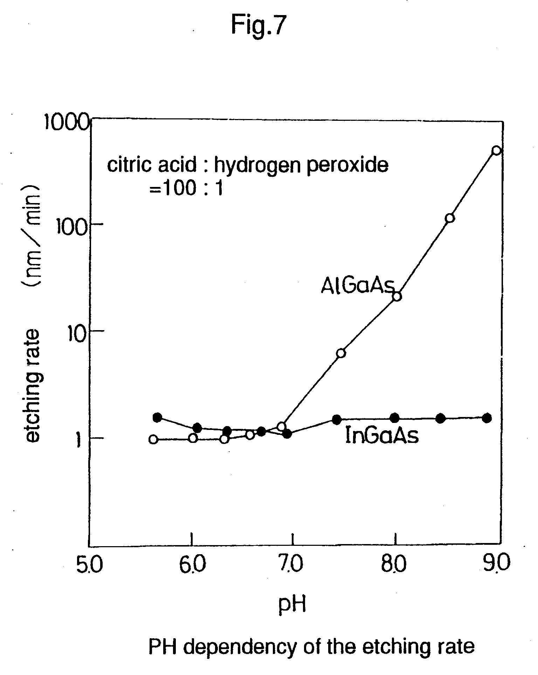

Figure 7 is a diagram for explaining an etching solution according to a third embodiment of the present invention, and shows the pH dependency of etching rate against AlGaAs and InGaAs, of a solution which is a mixture solution of citric acid and hydrogen peroxide mixed in a volume ratio of 100:1. Similarly to the above first and second embodiments, generally known organic acid may be employed, but in this third embodiment citric acid is employed. The etching solution of organic acid and hydrogen peroxide mixed in a volume ratio within a range of 1:1 to 200:1, shows the pH dependency of the etching rate against AlGaAs and InGaAs similar to that shown in figure 7.

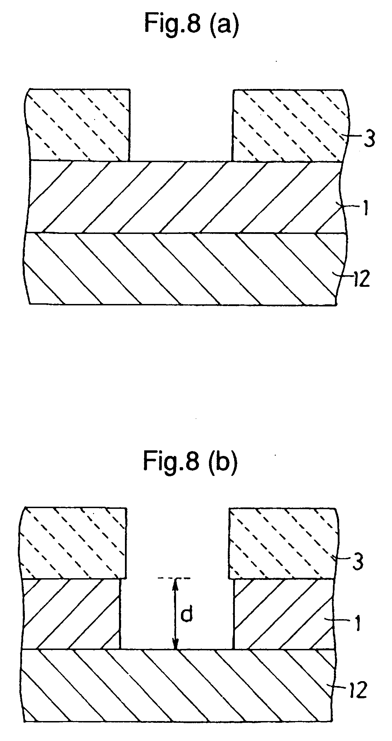

Figure 8 is a diagram showing an etching method according to the third embodiment of the present invention. Reference numeral 1 designates an n type AlGaAs layer, reference numeral 12 designates a p type InGaAs layer, and reference numeral 3 designates photoresist.

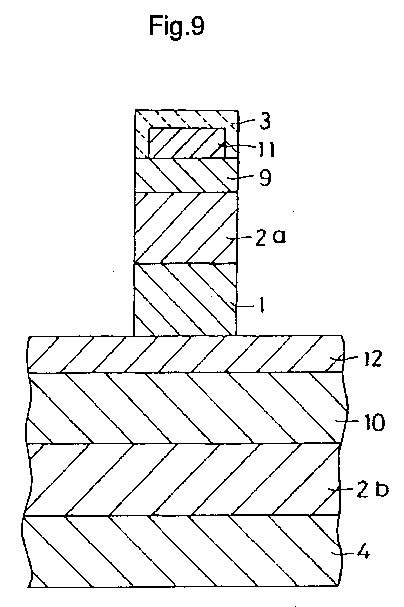

Figure 9 is a diagram for explaining the base surface exposing etching of an HBT, where reference numeral 11 designates an emitter electrode and reference numeral 3 designates photoresist.

The impurity concentration and the thicknesses of the respective layers of this HBT are as in the following table 3.

**Table 3**

| layer | impurity concentration | thickness |
|---|---|---|
| GaAs substrate 4 | | |
| n⁺ type GaAs collector contact layer 2b | 2 x 10¹⁸cm⁻³ | 2,000Å |
| n⁻ type GaAs collector layer 10 | 2 x 10¹⁷cm⁻³ | 2,000Å |
| p⁺ type InGaAs base layer 12 | 1 x 10¹⁹cm⁻³ | 500Å |
| n type AlGaAs emitter layer 1 | 5 x 10¹⁷cm⁻³ | 500Å |
| n type GaAs emitter layer 2b | 2 x 10¹⁸cm⁻³ | 1,000Å |
| InGaAs emitter contact layer 9 | 2 x 10¹⁸cm⁻³ | 2,000Å |

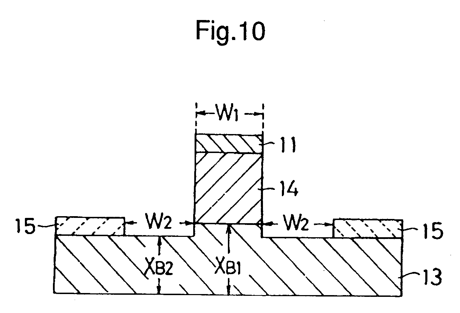

Figure 10 is a diagram for explaining that the external base resistance increases when the base surface exposing etching is performed in the conventional technique, where reference numeral 11 designates an emitter electrode, reference numeral 13 designates a base layer, reference numeral 14 designates an emitter layer, and reference numeral 15 designates a base electrode.

The etching solution and the etching method of this third embodiment will be described as in the following.

As shown in figure 7, when citric acid is used as organic acid, the citric acid and hydrogen peroxide is mixed in a volume ratio of 100:1, and basic compound such as ammonia is added thereto to adjust the pH to be above 7.0, a selective etching of AlGaAs and InGaAs is enabled. In other words, in the range of pH above 7.0, the etching rate of AlGaAs is large and the etching rate of InGaAs is small, thereby enabling largely etching AlGaAs and hardly etching InGaAs. That is, as shown in figure 8, by performing etching to the two layer structure of p⁺ InGaAs layer 12 and n AlGaAs layer 1, it is possible to etch only n type AlGaAs layer 1 and stop the etching just at the p⁺ InGaAs layer 12. This can be used in the base surface exposing etching of HBT as shown in figure 9, and the etching depth of n type AlGaAs layer 1 can be controlled at high preciseness, thereby the p⁺ type InGaAs base layer 12 is hardly overetched.

The base resistance R_{B} in the HBT is represented by the following formula (3), 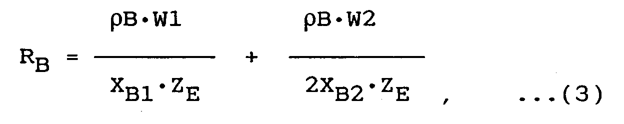
where Z_{E} is an emitter length.

When performing a base surface exposing etching in the prior art, the external base resistance in the second term in the formula (3) increases due to that the base layer 13 is overetched, and thereby the X_{B2} increases, whereby the device characteristic such as the maximum oscillation frequency is deteriorated. On the contrary, in the third embodiment of the present invention, by performing a high selectivity etching of AlGaAs/InGaAs employing the above-described etching solution, the etching can be stopped at the upper surface of the base layer 13 of the HBT, whereby the increase of the external base resistance is prevented.

### Embodiment 4.

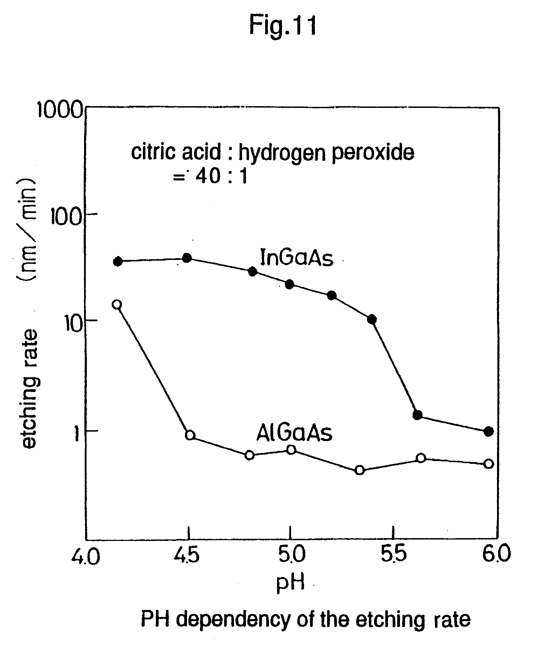

Figure 11 is a diagram for explaining an etching solution according to a fourth embodiment of the present invention, and the pH dependency of the etching rate for InGaAs and AlGaAs, of a solution employing citric acid as organic acid, and the citric acid and the hydrogen peroxide is mixed in a volume ratio of 40:1. As similarly in the first, the second, and the third embodiment, while citric acid is employed in this fourth embodiment, a generally known organic acid may be employed as organic acid. The volume ratio of the organic acid and the hydrogen peroxide may be in a range of 1:1 to 200:1, presenting the similar pH dependency of the etching rate against AlGaAs and InGaAs as that shown in figure 11.

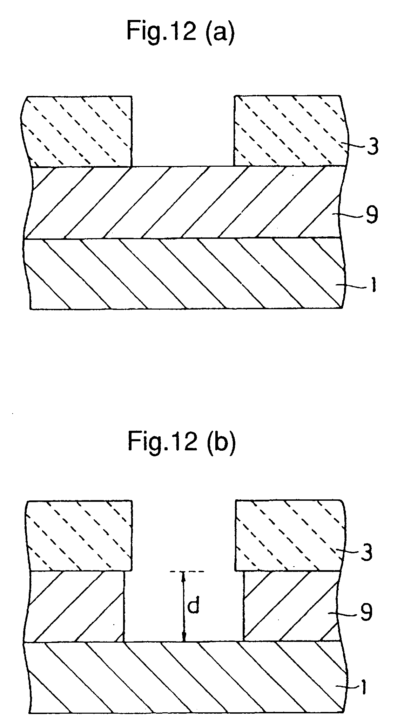

Figure 12 is a diagram for explaining an etching solution according to a fourth embodiment of the present invention, where reference numeral 1 designates an n type AlGaAs layer, reference numeral 9 designates an InGaAs layer, and reference numeral 3 designates photoresist.

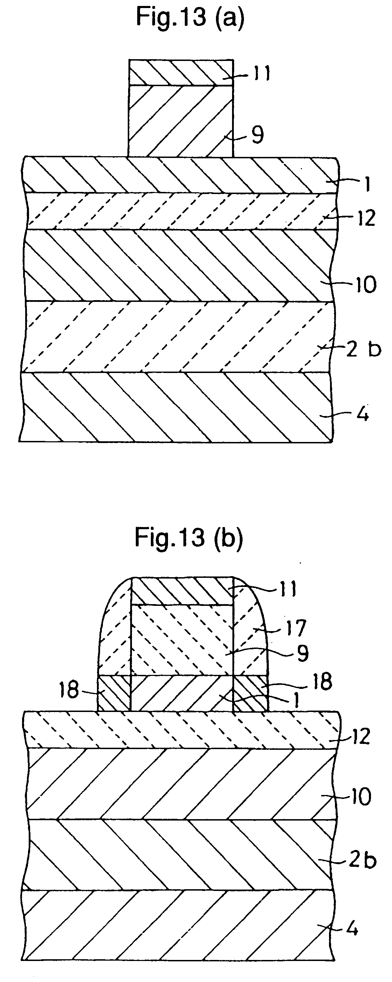

Figure 13(a) and 13(b) are diagrams for explaining a method for producing an emitter layer that is depleted, of an HBT. In figure 13, reference numeral 11 designates an emitter electrode, reference numeral 17 designates an SiO₂ side wall, and reference numeral 18 designates an AlGaAs emitter layer that is depleted.

The impurity concentration, and the thickness of the layers of the HBT are shown in the following table 4.

**Table 4**

| layer | impurity concentration | thickness |
|---|---|---|
| type GaAs substrate 4 | | |
| n⁺ type GaAs collector contact layer 2b | 2 x 10¹⁸cm⁻³ | 2,000Å |
| n⁻ type GaAs collector layer 10 | 1 x 10¹⁷cm⁻³ | 2,000Å |
| p⁺ type InGaAs base layer 12 | 1 x 10¹⁹cm⁻³ | 500Å |
| n type AlGaAs emitter layer 1 | 5 x 10¹⁷cm⁻³ | 500Å |
| InGaAs emitter layer 9 | 2 x 10¹⁸cm⁻³ | 1,000Å |

A description is given of the etching solution and the etching method of the fourth embodiment.

As shown in figure 11, when citric acid is employed as organic acid, the volume ratio of the citric acid and the hydrogen peroxide is 40:1, and basic compound such as ammonia is added thereto to adjust the pH to be 4.5 to 5.5, a selective etching between InGaAs and AlGaAs is enabled.

That is, in the range of pH 4.5 to 5.5, the etching rate of InGaAs is large and the etching rate of AlGaAs is small, thereby InGaAs is largely etched and AlGaAs is hardly etched. Therefore, as shown in figure 12, an etching is performed to the two layer structure of n type AlGaAs layer 1 and InGaAs layer 9 using the photoresist 3 as a mask employing the etching solution, and thereby only the InGaAs layer 9 is etched with the etching stopped at the n type AlGaAs layer 1.

In producing, for example, an AlGaAs emitter layer 18 of an HBT that is depleted, it is possible to employ the etching solution of the fourth embodiment and the etching solution of the third embodiment as shown in figures 13(a) and 13(b) and as described below:
When an etching is performed employing an etching solution of the fourth embodiment to the InGaAs emitter layer 9 using an emitter electrode 11 as a mask as shown in figure 13(a), the etching can be stopped just at the n type AlGaAs layer 1, thereby the etching depth can be controlled at high preciseness.

After producing SiO₂ side wall 17 at the side walls of the emitter layer 9 and the emitter electrode 11, an etching is performed to the AlGaAs emitter layer 1 employing the etching solution according to the third embodiment as shown in figure 13(b), and an AlGaAs layer 18 that is depleted is produced.

In this fourth embodiment, a high selectivity etching of InGaAs/AlGaAs is performed using the above-described etching solution, thereby the production of an AlGaAs emitter layer 18 of an HBT that is depleted can be produced easily and at high preciseness.

### Embodiment 5.

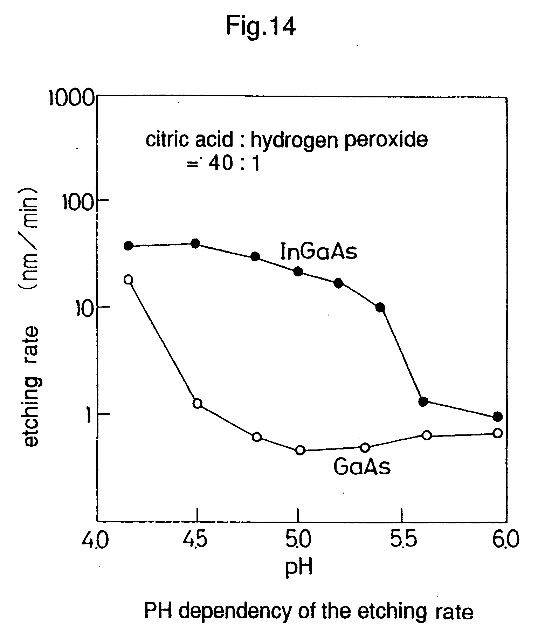

Figure 14 is a diagram for explaining an etching solution according to a fifth embodiment of the present invention. Figure 14 shows the pH dependency of the etching rate for InGaAs and GaAs, of the etching solution which is obtained by that citric acid is employed as organic acid, the citric acid and the hydrogen peroxide are mixed in a volume ratio of 40:1. Similarly as in the first to fourth embodiments, while citric acid is employed in this fifth embodiment, generally known organic acid can be employed as organic acid. The volume ratio of the organic acid and the hydrogen peroxide may be in a range of 1:1 to 200:1, thereby presenting the pH dependency of the etching rate against AlGaAs and InGaAs similar to that shown in figure 14.

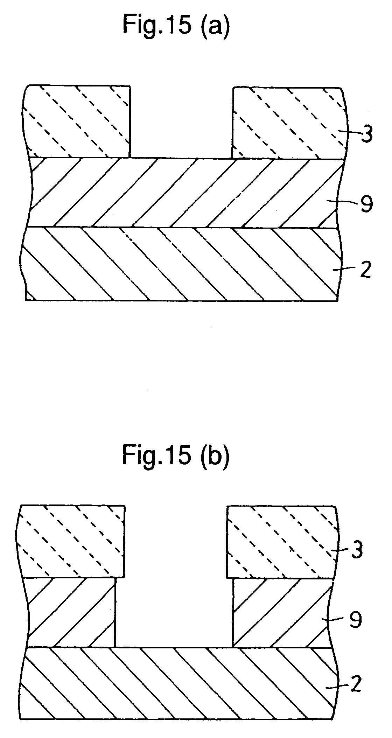

Figure 15 shows an etching method according to a fifth embodiment of the present invention. In figure 15, reference numeral 2 designates an n⁺ type GaAs layer, reference numeral 9 designates an InGaAs layer, and reference numeral 3 designates photoresist.

Figure 16 is a diagram for explaining the etching of an emitter layer of an HBT, where reference numeral 11 designates an emitter electrode.

The impurity concentration and the thickness of respective layers of this HBT are shown below.

**Table 5**

| layer | impurity concentration | thickness |
|---|---|---|
| GaAs substrate 4 | | |
| n⁺ type GaAs collector contact layer 2b | 2 x 10¹⁸cm⁻³ | 2,000Å |
| n⁻ type GaAs collector layer 10 | 1 x 10¹⁷cm⁻³ | 2,000Å |
| p⁺ type InGaAs base layer 12 | 1 x 10¹⁹cm⁻³ | 500Å |
| n type AlGaAs emitter layer 1 | 5 x 10¹⁷cm⁻³ | 500Å |
| n type GaAs emitter layer 10a | 2 x 10¹⁸cm⁻³ | 1,000Å |
| InGaAs emitter layer 9 | 2 x 10¹⁸cm⁻³ | 1,000Å |

A description is given of the etching solution and the etching method of this fifth embodiment.

As shown in figure 14, when citric acid is employed as organic acid, the citric acid and the hydrogen peroxide are mixed in a volume ratio of 40:1, and basic compound such as ammonia is added thereto to adjust the pH to be 4.5 to 5.5, a selective etching of InGaAs and GaAs is enabled. In other words, in the range of pH 4.5 to 5.5, the etching rate of InGaAs is large and the etching rate of GaAs is small, thereby InGaAs can be largely etched and GaAs is hardly etched. Therefore, against the two layer structure of n type GaAs layer 10 and InGaAs layer 9, only the InGaAs layer 9 is etched by the above-described solution using the photoresist 3 as a mask, with the etching stopped just at the n type GaAs layer 10 as shown in figure 15. When an etching of the InGaAs emitter layer 9 of the HBT is performed as shown in figure 16, the InGaAs emitter layer 9 can be etched easily and at high preciseness selectively with the n type GaAs emitter layer 10a, thereby the characteristics of the HBT is made uniform.

In this fifth embodiment, a high selectivity etching of InGaAs/GaAs can be performed using the above-described etching solution, thereby a heterostructure device such as HBT can be produced.

As described above, according to the etching solution and the etching method of the present invention, by that organic acid and hydrogen peroxide are mixed in a volume ratio of 1:1 to 200:1 and basic material is added thereto, thereby to adjust the pH, an etching solution presenting an eminent difference in the etching rate between GaAs/AlGaAs, GaAs/InGaAs, AlGaAs/InGaAs, InGaAs/AlGaAs, and InGaAs/GaAs is obtained, enabling a high selectivity etching easily and at high preciseness. Thereby, a precise control of an etching for a heterostructure semiconductor is enabled.

## Claims

1. An etching solution for etching a GaAs layer (2) selectively with an AlGaAs layer (1) against a layer structure comprising said AlGaAs layer (1) and said GaAs layer (2) produced on said AlGaAs layer (1), comprising:
mixed solution that is obtained from organic acid and hydrogen peroxide mixed in a volume ratio of 1:1 to 200:1 with basic material being added thereto to an amount that produces pH of 6.0 to 8.0.

2. The semiconductor etching solution of claim 1, where the organic acid and the hydrogen peroxide are mixed in a volume ratio of 100:1.

3. An etching method for etching a GaAs layer (2) selectively with an AlGaAs layer (1) against a layer structure comprising said AlGaAs layer (1) and said GaAs layer (2) produced on said AlGaAs layer (1), comprising:
employing an etching solution comprising mixed solution that is obtained from organic acid and hydrogen peroxide mixed in a volume ratio of 1:1 to 200:1 with basic material being added thereto to an amount that produces pH of 6.0 to 8.0.

4. The semiconductor etching method of claim 3, where the organic acid and the hydrogen peroxide are mixed in a volume ratio of 100:1.

5. The semiconductor etching method of claim 3, where said layer structure comprises an n type AlGaAs electron supply layer (1) and an n⁺ type GaAs cap layer (2) produced on said n type AlGaAs electron supply layer (1), of a high electron mobility transistor.

6. An etching solution for etching a GaAs layer (2) selectively with an InGaAs layer (9) against a layer structure comprising said InGaAs layer (9) and said GaAs layer (2) produced on said InGaAs layer (9), comprising:
mixed solution that is obtained from organic acid and hydrogen peroxide mixed in a volume ratio of 1:1 to 200:1 with basic material being added thereto to an amount that produces pH of above 6.0.

7. The semiconductor etching solution of claim 6, where the organic acid and the hydrogen peroxide are mixed in a volume ratio of 100:1.

8. A semiconductor etching method for etching a GaAs layer (2) selectively with an InGaAs layer (9) against a layer structure comprising said InGaAs layer (9) and said GaAs layer (2) produced on said InGaAs layer (9), comprising:
employing an etching solution comprising mixed solution that is obtained from organic acid and hydrogen peroxide mixed in a volume ratio of 1:1 to 200:1 with basic material being added to an amount that produces pH of above 6.0.

9. The semiconductor etching method of claim 3, where the organic acid and the hydrogen peroxide are mixed in a volume ratio of 100:1.

10. The semiconductor etching method of claim 8, where said layer structure comprises an n type InGaAs layer (9) and an n⁺ type GaAs cap layer (2) produced on said n type InGaAs layer (9), of a metal semiconductor field effect transistor.

11. A semiconductor etching solution for etching an AlGaAs layer (1) selectively with an InGaAs layer (12) against a layer structure comprising said InGaAs layer (12) and said AlGaAs layer (1) produced on said InGaAs layer (12), comprising:
mixed solution that is obtained from organic acid and hydrogen peroxide mixed in a volume ratio of 1:1 to 200:1 with basic material being added thereto to an amount that produces pH of above 7.0.

12. The semiconductor etching solution of claim 11, where the organic acid and the hydrogen peroxide are in a volume ratio of 100:1.

13. An etching method for etching an AlGaAs layer (1) selectively with an InGaAs layer (12) against a layer structure comprising said InGaAs layer (12) and said AlGaAs layer (1) produced on said InGaAs layer (12), comprising:
employing an etching solution comprising mixed solution that is obtained from organic acid and hydrogen peroxide mixed in a volume ratio of 1:1 to 200:1 with basic material being added thereto to an amount that produces pH of above 7.0.

14. The etching method of claim 13, where the organic acid and the hydrogen peroxide are mixed in a volume ratio of 100:1.

15. The semiconductor etching method of claim 13, where said layer structure comprises a p⁺ type InGaAs base layer (12) and an n⁺ type AlGaAs emitter layer (1) produced on said p⁺ type InGaAs base layer (12), of a heterojunction bipolar transistor.

16. An etching solution for etching an InGaAs layer (9) selectively with an AlGaAs layer (1) against a layer structure comprising said AlGaAs layer (1) and said InGaAs layer (9) produced on said AlGaAs layer (1), comprising:
mixed solution that is obtained from organic acid and hydrogen peroxide mixed in a volume ratio of 1:1 to 200:1 with basic material being added thereto to an amount that produces pH of 4.5 to 5.5.

17. The etching solution of claim 16, where the organic acid and the hydrogen peroxide are in a volume ratio of 40:1.

18. An etching method for etching an InGaAs layer (9) selectively with an AlGaAs layer (1) against a layer structure comprising said AlGaAs layer (1) and said InGaAs layer (9) produced on said AlGaAs layer (1), comprising:
employing an etching solution comprising mixed solution that is obtained from organic acid and hydrogen peroxide mixed in a volume ratio of 1:1 to 200:1 with basic material being added thereto to an amount that produces pH of 4.5 to 5.5.

19. The etching method of claim 18, where the organic acid and the hydrogen peroxide are mixed in a volume ratio of 40:1.

20. The etching method of claim 18, where said layer structure comprises an n type AlGaAs emitter layer (1) and an n⁺ type InGaAs emitter layer (9) produced on said n type AlGaAs emitter layer (1), of an HBT.

21. A semiconductor etching solution for etching an InGaAs layer (9) selectively with a GaAs layer (10a) against a layer structure comprising an GaAs layer (10a) and a InGaAs layer (9) produced on said GaAs layer (10a), comprising:
mixed solution that is obtained from organic acid and hydrogen peroxide mixed in a volume ratio of 1:1 to 200:1 with basic material being added thereto to an amount that produces pH of 4.5 to 5.5.

22. The semiconductor etching solution of claim 21, where the organic acid and the hydrogen peroxide are in a volume ratio of 40:1.

23. An etching method for etching an InGaAs layer (9) selectively with a GaAs layer (10a) against a layer structure comprising said GaAs layer (10a) and said InGaAs layer (9) produced on said GaAs layer (10a), comprising:
employing an etching solution comprising mixed solution that is obtained from organic acid and hydrogen peroxide mixed in a volume ratio of 1:1 to 200:1 with basic material being added to an amount thereto that produces pH of 4.5 to 5.5.

24. The etching method of claim 23, where the organic acid and the hydrogen peroxide are mixed in a volume ratio of 40:1.

25. The etching method of claim 23, where said layer structure comprises an n type GaAs emitter layer (10a) and an n⁺ type InGaAs emitter layer (9) produced on said n type GaAs emitter layer (10a), of an HBT.
